# EUROPEAN PATENT SPECIFICATION

(11) **EP 2 810 306 B1**
(45) Date of publication and mention of the grant of the patent: **10.03.2021**
(21) Application number: 13713504.2
(22) Date of filing: 29.01.2013
(51) Int. Cl.: H01L 33/00, H01L 33/22

(54) **PRODUCING LIGHT EMITTING DEVICES AT VARIABLE FLUX LEVELS**
HERSTELLUNG VON LEUCHTDIODEN MIT VARIABLER AUSGANGSLEISTUNG
PRODUCTION DE DIODES ÉLECTRO-LUMINESCENTES AVEC DES FLUX DE SORTIE VARIABLES

(30) Priority: 02.02.2012 US 201261594106 P
(43) Date of publication of application: 10.12.2014
(73) Proprietor: Lumileds LLC, San Jose, CA 95131 (US)
(72) Inventor: MARTIN, Paul, Scott, NL-5656 AE Eindhoven (NL); HNG, Tiang, Chuan, NL-5656 AE Eindhoven (NL); ISHIKAWA, Tomonari, NL-5656 AE Eindhoven (NL)
(74) Representative: Rüber, Bernhard Jakob
(86) International application number: PCT/IB2013/050743
(87) International publication number: WO 2013/114270

(56) References cited:
- WO-A1-2013/050917
- US-A- 5 040 044
- US-A1- 2005 082 562
- US-A1- 2008 105 882
- US-A1- 2008 283 865
- US-A1- 2011 133 231
- US-A1- 2011 204 412
- FUJII T ET AL: "Increase in the extraction efficiency of GaN-based light-emitting diodes via surface roughening", APPLIED PHYSICS LETTERS, AIP, AMERICAN INSTITUTE OF PHYSICS, MELVILLE, NY, US, vol. 84, no. 6, 9 February 2004 (2004-02-09), pages 855-857, XP012062026, ISSN: 0003-6951, DOI: 10.1063/1.1645992
- FANG ET AL: "Studies of improving light extraction efficiency of high power blue light-emitting diode by photo-enhanced chemical etching", JOURNAL OF CRYSTAL GROWTH, ELSEVIER, AMSTERDAM, NL, vol. 298, 13 February 2007 (2007-02-13), pages 703-705, XP005864121, ISSN: 0022-0248, DOI: 10.1016/J.JCRYSGRO.2006.10.124

## Description

### FIELD OF THE INVENTION

This invention relates to the field of light emitting devices (LEDs), and in particular to a light emitting device having a light emitting surface that can be modified to enhance the light extraction efficiency of the device.

### BACKGROUND OF THE INVENTION

The use of roughened emitting surfaces is one of several techniques commonly used to enhance LED extraction efficiency in LED designs. Roughening may be applied to different types of LED structures including InGaN, AlInGaP systems, in flip chip bonded and vertical thin film device architectures, and others.

USP 7,875,533, "PACKAGE INTEGRATED THIN FILM LED, AND DEVICES", issued to John Epler, Paul Martin and Michael Krames on 25 January 2011, discloses roughening of the GaN light emitting surface of an LED to enhance the light extraction efficiency using a photo-electrochemical etch process using a KOH solution. The depth of the etching is controlled using an etch stop layer that is grown during the formation of the light emitting device. In like manner, USPA 2010/0025717, USPA 2009/0146170, USPA 2008/0113463, and USP 7,749782 also disclose techniques for improving light extraction efficiency by roughening the light emitting surface.

FUJIIT ET AL: "Increase in the extraction efficiency of GaN-based light emitting diodes via surface roughening". APPLIED PHYSICS LETTERS, AMERICAN INSTITUTE OF PHYSICS, vol. 84, no. 6. pages 855-857, discloses a specific surface roughening process in which the output power of the LED is increased when the surface roughening etching time is increased from 2 minutes to 10 minutes. US 2005/082562 A1 discloses a specific surface roughening process in which the brightness of the LED is increased by increasing the surface roughness. US 2008/105882 A1 discloses that the surface roughness can be controlled by the etching conditions.

Each of the above referenced methods creates a substantially uniformly roughened surface that allows for maximum light extraction, often allowing for the extraction of as much as twice the light as the original unroughened surface. With continuing increases in light emission efficiency, a doubling of the light extraction efficiency may be undesirable in certain applications. For example, it may be desirable to limit the total light output to a customer's maximum-flux specification, to conform to a particular standard, or to achieve a particular lighting effect.

Consider, for example, providing LED lamps for automobile headlights or taillights, typically comprising multiple light emitting elements. Standards exist that set a certain minimum and maximum luminescent output. The design of a particular lamp, including the number of light emitting elements, the shape of reflector and lens elements, etc. to achieve the desired luminescent output is fundamentally dependent upon the amount of light (flux) that can be provided by each light emitting element. Conventionally, as improved technologies provide for more light per light emitting element, the design of the 'next-generation' lamps takes advantage of this increased light output to achieve cost efficiencies while still maintaining the total luminescent output between the required minimum and maximum limits.

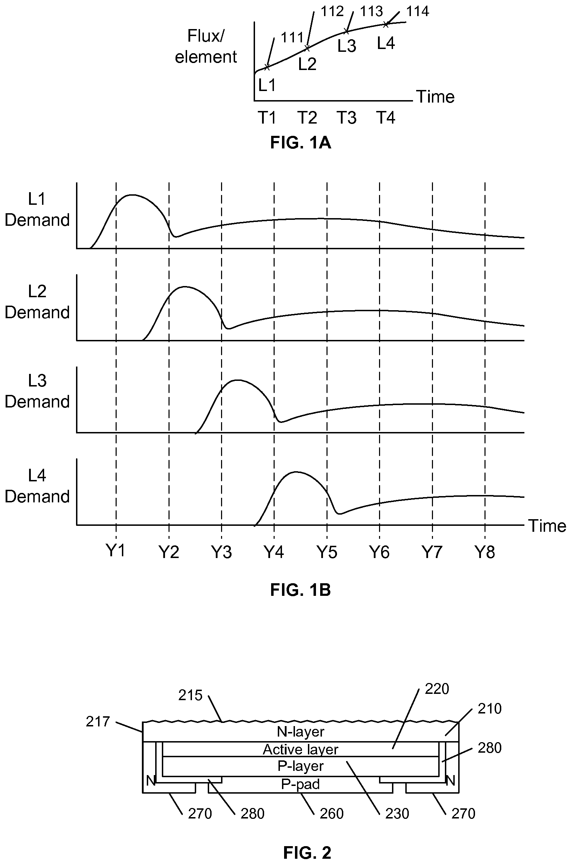

Although each next-generation lamp may be optimized for cost or other efficiencies, these efficiencies may be sub-optimal in a more global sense. Consider, for example, the progression of technologies exhibited in FIG. 1A. Over time, the achievable flux per LED element can be expected to increase in some manner based on advancements in technologies associated with LED design and manufacture. At any particular point in time, a given technology is selected for the design of a lamp; illustrated in FIG. 1A are four points in time T1-T4 when four different lamps L1-L4, or four different models of a lamp, are designed using the technology available at that time for providing an achievable amount of flux per LED element 111-114. For example, at time T2, the technology will have advanced such that the achievable flux per element 112 for use in lamp L2 is greater than the flux per element 111 that was achievable at an earlier time T1 for use in lamp L1. These lamps L1-L4 may be, for example, lamps used for different years of one or more models of automobiles.

FIG. 1B illustrates an example set of demands for such lamps L1-L4 over time. Lamp L1 may be used in an automobile model produced, for example, in year Y1. The demand for the lamp L1 will peak during the production of that model, then drop off when that model is no longer being produced, then reaching annual levels based on the need for replacement of these lamps for that model. Lamps L2-L4, used for subsequently produced models of autombiles, will exhibit a similar demand pattern.

As noted above, each of the lamps L1-L4 will use the available LED technology to achieve a cost-efficient design. However, because each of the lamps L1-L4 use an LED technology that provides a particular level of flux per LED element 111-114, the provider of these lamps L1-L4 must maintain production of each of these LED technologies. That is, in year Y4, because there is a demand for each of the lamps L1-L4, and each of the lamps L1 - L4 were designed based on technologies that provided a corresponding flux per LED element 111-114, each of these technologies must be maintained for producing LED elements having the required flux per LED element 111-114.

In addition to introducing manufacturing complexities for maintaining various technologies, the cost of manufacturing each LED element may be sub-optimal, particularly as the demand for older technologies decreases, and the economies of mass production cannot be achieved. Additionally, as time progresses, newer technologies can be expected to provide LED elements with more flux at less cost. Thus, the cost of producing the LED elements used in lamp L4 may be less than the cost of producing the LED elements used in lamp L1, even though the LED elements used in lamp L4 produce a significantly higher flux per element 114.

However, even though the potential flux per unit cost of using the LED technology used in lamp L4 may be significantly lower than the cost of using the LED technology used in lamp L1, the LED elements used in lamp L4, with flux 114, may not be useable in lamp L1, which was designed for a lower flux per element 111, if the luminance output of lamp L1 with LED elements having flux 114 exceeds some specified maximum luminance output for the use of lamp L1.

### SUMMARY OF THE INVENTION

It would be advantageous to be able to reliably and/or inexpensively control the light flux of a light emitting element to allow the use of a common LED technology among applications designed for different flux levels. It would also be advantageous to be able to control the flux of a light emitting element without substantially modifying the process used to produce the light emitting element.

To better address one or more of these concerns, in an embodiment of this invention, conventional techniques are used to modify the surface of a light emitting device, such as roughening the surface, to enhance the light extraction efficiency, but the degree of modification of the surface is controlled by controlling one or more of the parameters associated with the modification technique. A given LED technology will have some minimum flux without modification and some maximum flux with optimal modification. By characterizing the relationship between the parameters of the modification process and the resultant flux, the parameters of the modification process can be controlled to achieve a desired flux between the minimum and maximum flux achievable by the given LED technology.

### BRIEF DESCRIPTION OF THE DRAWINGS

The invention is explained in further detail, and by way of example, with reference to the accompanying drawings wherein:
FIG. 1A illustrates an example progression of LED technology over time with regard to achievable flux per LED element.
FIG. 1B illustrates an example use of progressive LED technologies in lamps over time.
FIG. 2 illustrates an example LED element.
FIG. 3A illustrates an example progression of surface roughening during a roughening process.
FIG. 3B illustrates a relationship between the increase in flux as a function of a parameter (time) of the roughening process.
FIG. 4 illustrates an example process for controlling roughening process parameters to achieve a desired flux between a minimum and maximum flux level.

Throughout the drawings, the same reference numerals indicate similar or corresponding features or functions. The drawings are included for illustrative purposes and are not intended to limit the scope of the invention.

### DETAILED DESCRIPTION

In the following description, for purposes of explanation rather than limitation, specific details are set forth such as the particular architecture, interfaces, techniques, etc., in order to provide a thorough understanding of the concepts of the invention. However, it will be apparent to those skilled in the art that the present invention may be practiced in other embodiments, which depart from these specific details. In like manner, the text of this description is directed to the example embodiments as illustrated in the Figures, and is not intended to limit the claimed invention beyond the limits expressly included in the claims. For purposes of simplicity and clarity, detailed descriptions of well-known devices, circuits, and methods are omitted so as not to obscure the description of the present invention with unnecessary detail.

As noted above, a variety of techniques may be used to modify the light emitting surface(s) of light emitting devices, the most common technique currently being used is a photo-electrochemical etch process. Accordingly, for ease of presentation and understanding, this invention is being presented using the paradigm of such an etching process.

FIG. 2 illustrates an example prior art Thin Film Flip Chip (TFFC) InGaN Light Emitting Device (LED) element. In this example device, a light emitting layer 220 is formed between an n-layer 210 and a p-layer 230. An external power source (not illustrated) provides power to the device via connections to pads 260 and 270. The p-pad 260 is coupled to the p-layer 230 and the n-contact layer 270 is coupled to the n-layer 210. A boundary material 280 isolates the n-contact layer 270 and n-layer 210 from the p-layer 230 and p-contact 240.

As noted above, to improve the light extraction efficiency, and thereby increase the flux provided by the LED element, the "top" surface 215 of the n-layer 210 maybe roughened, using, for example, a photo-electrochemical etch process using a KOH solution. Typically, a flux increase of as much as 100% may be achieved compared to an unroughened surface.

Co-pending U.S. patent application 61/585,673, "SIDEWALL ETCHING OF LED DIE TO IMPROVE LIGHT EXTRACTION", filed 12 January 2012 for Tiang Chuan Hng and Tomonari Ishikawa, Attorney docket 2011P002295US, discloses a photoelectrochemical etching technique that improves the light extraction efficiency by roughening the sidewalls of the LED die. In this application, each LED is situated in a solution of KOH and K₂S₂O₈ between a multi-directional light source and a mirror, and is illuminated for a duration of about 45 minutes to achieve an additional flux increase of about 30% compared to an LED with unroughened edges.

For the purposes of this disclosure and accompanying claims, "surface roughening" includes the roughening of any and all surfaces of the LED element, including edge surfaces 217.

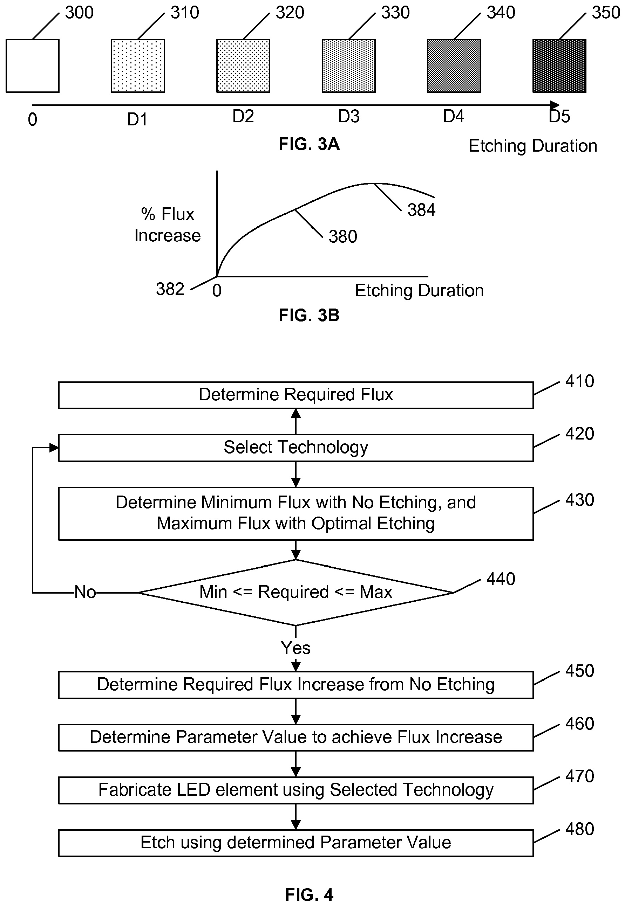

FIG. 3A illustrates an example progression of surface roughening during a roughening process. In this example, the varying degrees of surface roughening are produced by subjecting the surface to the roughening process for progressively longer durations of time. Before roughening, the surface is unroughened, as illustrated by the lack of features on the surface 300. After being exposed to the roughening process for a first time duration D1, the surface 310 exhibits some roughened features where some material from the surface has been removed, creating crevice-like features. After being exposed to the roughening process for a second total duration D2, the surface 320 exhibits increased roughened features, as the roughened features increase in surfaces 330-350 with increased exposure to the roughening process. This increase in roughening features may include an increase in the density of roughened features, or an increase in the intensity (depth gradient) of the roughened features, or a combination of both.

Although the result of time duration of exposure to a roughening process is illustrated in FIG. 3A, one of skill in the art will recognize that other parameters may produce varying degrees of roughening, as well. For example, in a chemical etching process, the varying degrees of surface roughening 310-350 may be produced by varying degrees of chemical concentration of the etching material. In a photo-lithographic process, the varying degrees of surface roughening 310-350 may be produced by varying the coarseness of the lithographic pattern. In a laser etching process, the intensity of the laser may be varied.

In like manner, as disclosed in copending U.S. patent application 61/584,836, "CONTROLLED LED LIGHT OUTPUT BY SELECTIVE AREA ROUGHENING", filed 10 January 2012 for Mac Benedict, Paul Martin, and Dave Kharas, the proportion of the area that is roughened is controlled. The roughened area enhances the light extraction efficiency while the unroughened area does not enhance the extraction efficiency, the proportion of roughened area to unroughened area determining the overall increase in light extraction efficiency. One of skill in the art will recognize that multiple surface processing parameters may be controlled to achieve the desired amount of light extraction efficiency.

FIG. 3B illustrates a relationship 380 between the increase in flux as a function of a parameter of the roughening process. Continuing with the example of FIG. 3A, the plotted line 380 illustrates the increase in flux that may be achieved as a function of the time that the surface is subjected to the roughening process. As illustrated, there is a minimal (zero) increase in flux 382 if the surface is not subjected to the roughening process (duration = 0), and a maximum increase in flux 384 at some optimal value of the parameter of the roughening process. Between zero and the optimal value of the roughening parameter, the flux will be between the minimum and maximum flux levels.

One of skill in the art will recognize that the relationship illustrated in FIG. 3B may not be as distinct as the plotted line 380 may indicate. That is, the plotted line 380 may represent an average increase among a number of LED elements subjected to the roughening process for the given time, and there likely will be some degree of variance about this value. However, once the variance is characterized for a given roughening parameter, conventional manufacturing quality control techniques may be used to assure that bounds can be estimated for an achievable flux increase at a given parameter value.

As noted above, there may be a variety of roughening parameters that can be controlled, and the parameter, or set of parameters, that exhibits the least variance would generally be preferred, assuming the costs associated with controlling each parameter are comparable.

FIG. 4 illustrates an example process for controlling roughening process parameters to achieve a desired flux between a minimum and maximum flux level. At 410, the required flux per LED element is determined for the particular application, for example, being suitable for use in a particular lamp, based on the required flux per LED element.

At 420, a particular LED technology is selected. For example, the technology having the greatest flux per unit cost may be the preferred choice, provided that it is suitable for use in the current application.

To determine the suitability of the selected technology, the minimum and maximum achievable flux per element is determined, based on control of the degree of roughening, at 430. If the required flux is not between the achievable minimum and maximum flux using this technology, at 440, a different technology, if available, is similarly assessed at 420-440.

When a suitable technology is identified, at 440, the required degree of flux increase over the minimum flux is determined, at 450, and the corresponding roughening parameter value is determined, at 460, using the previously determined relationship between the roughening parameter and increased flux over an unroughened surface. Plotted line 380 is one example of a roughening/flux relationship.

The selection of the particular roughening parameter value may be based on the aforementioned variance and the requirements for the required flux. If, for example, the application requires that the flux does not exceed a particular value, the parameter value is selected such that most (e.g. 95%) of the elements produced will be below the required flux, based on the expected distribution of flux per element at the selected parameter value. The expected distribution of flux per element may also be used to assure that an acceptable number of the produced elements are able to achieve a required minimum flux at the selected parameter value.

The LED elements are fabricated, at 470, then the surface is roughened using the determined roughening parameter value, at 480. For example, if the time that the surface is subjected to the roughening process is the parameter used to control the degree of roughening, the LED elements are subjected to the roughening process for the determined roughening time. If the concentration of etching solution is the parameter used to control the degree of roughening, the LED elements are subjected to the roughening process of the determined concentration. One of skill in the art will also recognize that a combination of parameters may be controlled to achieve a desired degree of roughening, such as controlling both the concentration of etching solution and the etching time.

As can be seen, by determining the relationship between flux of an LED element and a roughening parameter, the flux of the LED element may be controlled by controlling the value of the roughening parameter. In this manner, for example, with reference to FIG. 1B, all of the demand for lamps L1-L4 in year Y4 and beyond could be satisfied using the technology used for the LEDs of lamp L4, eliminating the need to maintain the technologies used for the LEDs of lamps L1-L3. That is, to make the LED elements for lamp L1, the LED elements of lamp L4 are fabricated as in the production of lamp L4, but the subsequent roughening process is controlled to provide the required lumens per element 111, suitable for use in lamp L1. In like manner, LED elements for lamps L2 and L3 will be similarly fabricated, but roughened to provide the respective required lumens per element 112 and 113.

While the invention has been illustrated and described in detail in the drawings and foregoing description, such illustration and description are to be considered illustrative or exemplary and not restrictive; the invention is not limited to the disclosed embodiments.

For example, it is possible to operate the invention in an embodiment wherein different surfaces of the LED element are roughened to different degrees than other surfaces, thereby achieving a desired light output distribution, with a controlled flux in each direction. One of skill in the art will recognize that the degree of control may be dependent upon the stage of manufacturing at which the control is applied. If, as in the example of this disclosure, the controlled etching is applied to the edges of the LED device, the LED device will need to be singulated before the edge-etching is applied. In other applications, applying and controlling the surface roughening at the wafer level, before singulation, may be sufficient to achieve the desired control of light output efficiency.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. Any reference signs in the claims should not be construed as limiting the scope.

## Claims

1. A method for controlling roughening process parameters for a light emitting device, comprising:
determining (410) a required flux per light emitting device for an application,
selecting (420) a light emitting device technology,
determining (430) the minimum and maximum achievable flux per light emitting device of the selected light emitting device technology based on control of a degree of roughening,
checking (440) if the required flux is between the achievable minimum and maximum flux, wherein a different light emitting device technology is selected if the required flux is between the achievable minimum and maximum flux and the different light emitting device technology is assessed,
determining (450) the required degree of flux increase over the minimum flux,
determining a relationship between a process parameter of the selected technology and a flux achievable by modifying a surface of a light emitting element using the process parameter, wherein the process parameter corresponds to a parameter that affects a roughening of the surface of the light emitting element determining (460) a select value of the process parameter that will achieve the required flux based on the relationship, and
modifying (480) the surface of the light emitting element using the select value of the processing parameter.

2. The method of claim 1, including singulating the light emitting element before modifying the surface.

3. The method of claim 1, including providing the light emitting element as a plurality of light emitting elements on a wafer, and wherein the surface is modified while the light emitting element is a part of the wafer, before singulating the light emitting element.

4. The method of claim 1, wherein the required flux corresponds to an upper value of a distribution of flux values associated with the select value of the process parameter.

5. The method of claim 1, wherein the modifying of the surface includes a photo-electrochemical etch process.

6. The method of claim 1, wherein the process parameter includes a duration of subjecting the light emitting element to the modifying of the surface.

7. The method of claim 1, wherein the process parameter includes a concentration of an etching solution used to effect the modifying of the surface.

8. The method of claim 1, wherein the process parameter includes an intensity of light used to effect the modifying of the surface.

9. The method of claim 1, wherein the surface corresponds to one or more surfaces of the light emitting element.

10. The method of claim 9, wherein the one or more surfaces correspond to edge surfaces of the light emitting element.

## Patentansprüche

1. Verfahren zur Steuerung von Aufrauungsprozessparametern für eine Licht emittierende Vorrichtung, umfassend:
Bestimmen (410) eines erforderlichen Flusses pro Licht emittierender Vorrichtung für eine Anwendung,
Auswählen (420) einer Technologie für Licht emittierende Vorrichtungen,
Bestimmen (430) des erreichbaren Minimal- und Maximalflusses pro Licht emittierender Vorrichtung der ausgewählten Technologien für Licht emittierende Vorrichtungen basierend auf einer Steuerung eines Aufrauungsgrades,
Prüfen (440), ob der erforderliche Fluss zwischen dem erreichbaren Minimal- und Maximalfluss ist, wobei eine andere Technologie für Lichtemittierende Vorrichtungen ausgewählt wird, wenn der erforderliche Fluss zwischen dem erreichbaren Minimal- und Maximalfluss ist, und die andere Technologie für Licht emittierende Vorrichtungen festgelegt wird,
Bestimmen (450) des erforderlichen Grades von Flusserhöhung über den Minimalfluss,
Bestimmen einer Beziehung zwischen einem Prozessparameter der ausgewählten Technologie und einem Fluss, der durch Modifizieren einer Oberfläche eines Licht emittierenden Elements unter Verwendung des Prozessparameters erreicht werden kann, wobei der Prozessparameter einem Parameter entspricht, der eine Aufrauung der Oberfläche des Licht emittierenden Elements beeinflusst,
Bestimmen (460) eines Auswahlwerts des Prozessparameters, der den erforderlichen Fluss erreicht, basierend auf der Beziehung, und
Modifizieren (480) der Oberfläche des Licht emittierenden Elements unter Verwendung des Auswahlwerts des Verarbeitungsparameters.

2. Verfahren nach Anspruch 1, umfassend ein Vereinzeln des Licht emittierenden Elements vor dem Modifizieren der Oberfläche.

3. Verfahren nach Anspruch 1, umfassend ein Bereitstellen des Licht emittierenden Elements als eine Mehrzahl von Licht emittierenden Elementen auf einem Wafer, und wobei die Oberfläche vor dem Vereinzeln des Licht emittierenden Elements modifiziert wird, während das Licht emittierende Element ein Teil des Wafers ist.

4. Verfahren nach Anspruch 1, wobei der erforderliche Fluss einem oberen Wert einer Verteilung von Flusswerten entspricht, die mit dem Auswahlwert des Prozessparameter assoziiert sind.

5. Verfahren nach Anspruch 1, wobei das Modifizieren der Oberfläche einen photoelektrochemischen Ätzprozess umfasst.

6. Verfahren nach Anspruch 1, wobei der Prozessparameter eine Dauer umfasst, die das Licht emittierende Element dem Modifizieren der Oberfläche unterzogen wird.

7. Verfahren nach Anspruch 1, wobei der Prozessparameter eine Konzentration einer Ätzlösung umfasst, die zum Durchführen des Modifizierens der Oberfläche verwendet wird.

8. Verfahren nach Anspruch 1, wobei der Prozessparameter eine Intensität von Licht umfasst, die zum Modifizieren der Oberfläche verwendet wird.

9. Verfahren nach Anspruch 1, wobei die Oberfläche einer oder mehreren Oberflächen des Licht emittierenden Elements entspricht.

10. Verfahren nach Anspruch 9, wobei die eine oder die mehreren Oberflächen Kantenflächen des Licht emittierenden Elements entsprechen.

## Revendications

1. Procédé de contrôle de paramètres de traitement de rugosification d'un dispositif électroluminescent, comprenant :
la détermination (410) d'un flux requis par dispositif électroluminescent pour une application,
la sélection (420) d'une technologie de dispositif électroluminescent,
la détermination (430) du flux minimal et maximal pouvant être obtenu par dispositif électroluminescent de la technologie de dispositif électroluminescent sélectionnée sur la base du contrôle d'un degré de rugosification,
la vérification (440) du fait que le flux requis est compris entre le flux minimal et maximal pouvant être obtenu, dans lequel une technologie de dispositif électroluminescent différente est sélectionnée si le flux requis est compris entre le flux minimal et maximal pouvant être obtenu et la technologie de dispositif électroluminescent différente est évaluée,
la détermination (450) du degré requis d'augmentation de flux par rapport au flux minimal,
la détermination d'une relation entre un paramètre de traitement de la technologie sélectionnée et un flux pouvant être obtenu par modification d'une surface de l'élément électroluminescent au moyen du paramètre de traitement, dans lequel le paramètre de traitement correspond à un paramètre qui affecte une rugosification de la surface de l'élément électroluminescent déterminant (460) une valeur de sélection du paramètre de traitement qui obtiendra le flux requis sur la base de la relation, et
la modification (480) de la surface de l'élément électroluminescent au moyen de la valeur sélectionnée du paramètre de traitement.

2. Procédé selon la revendication 1, incluant la singularisation de l'élément électroluminescent avant la modification de la surface.

3. Procédé selon la revendication 1, incluant la fourniture de l'élément électroluminescent sous forme d'une pluralité d'éléments électroluminescents sur une tranche, et dans lequel la surface est modifiée alors que l'élément électroluminescent fait partie de la tranche, avant de singulariser l'élément électroluminescent.

4. Procédé selon la revendication 1, dans lequel le flux requis correspond à une valeur supérieure d'une répartition de valeurs de flux associées à la valeur sélectionnée du paramètre de traitement.

5. Procédé selon la revendication 1, dans lequel la modification de la surface inclut un traitement par gravure photo-électrochimique.

6. Procédé selon la revendication 1, dans lequel le paramètre de traitement inclut une durée de soumission de l'élément électroluminescent à la modification de la surface.

7. Procédé selon la revendication 1, dans lequel le paramètre de traitement inclut une concentration d'une solution de gravure utilisée pour effectuer la modification de la surface.

8. Procédé selon la revendication 1, dans lequel le paramètre de traitement inclut une intensité de lumière utilisée pour effectuer la modification de la surface.

9. Procédé selon la revendication 1, dans lequel la surface correspond à une ou plusieurs surfaces de l'élément électroluminescent.

10. Procédé selon la revendication 9, dans lequel les une ou plusieurs surfaces correspondent à des surfaces de bordure de l'élément électroluminescent.
